# EUROPÄISCHE PATENTSCHRIFT

(11) **EP 1 431 779 B1**
(45) Veröffentlichungstag und Bekanntmachung des Hinweises auf die Patenterteilung: **01.03.2006**
(21) Anmeldenummer: 03028983.9
(22) Anmeldetag: 17.12.2003
(51) Int. Cl.: G01T 1/29, H01J 47/00

(54) **Halbleiter-Detektor mit optimiertem Strahlungseintrittsfenster**
Semiconductor detector with an optimised entrance window
Détecteur à semiconducteur avec une fenêtre d'entrée optimisée

(30) Priorität: 20.12.2002 DE 10260229
(43) Veröffentlichungstag der Anmeldung: 23.06.2004
(73) Patentinhaber: Max-Planck-Gesellschaft zur Förderung der Wissenschaften e.V., 80539 München (DE); PNSensor GmbH, 80803 München (DE)
(72) Erfinder: Lechner, Peter, 83607 Holzkirchen (DE); Lutz, Gerhard, 81739 München (DE); Strüder, Lothar, 80803 München (DE)
(74) Vertreter: Hertz, Oliver

(56) Entgegenhaltungen:
- US-A- 4 688 067
- US-A- 4 885 620
- HARTMANN R ET AL: "Design and test at room temperature of the first silicon drift detector with on-chip electronics" ELECTRON DEVICES MEETING, 1994. TECHNICAL DIGEST., INTERNATIONAL SAN FRANCISCO, CA, USA 11-14 DEC. 1994, NEW YORK, NY, USA,IEEE, 11. Dezember 1994 (1994-12-11), Seiten 535-538, XP010131836 ISBN: 0-7803-2111-1
- FASOLI L ET AL: "Front-end electronics integrated on high resistivity semiconductor radiation detectors" ANALOG AND MIXED IC DESIGN, 1996., IEEE-CAS REGION 8 WORKSHOP ON PAVIA, ITALY 13-14 SEPT. 1996, NEW YORK, NY, USA,IEEE, US, 13. September 1996 (1996-09-13), Seiten 117-122, XP010213171 ISBN: 0-7803-3625-9
- FIORINI C ET AL: "Gamma-ray imaging detectors based on SDDs coupled to scintillators" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. 461, Nr. 1-3, 1. April 2001 (2001-04-01), Seiten 565-567, XP004240300 ISSN: 0168-9002

## Beschreibung

Die Erfindung betrifft einen Halbleiter-Detektor zur Detektion von elektromagnetischer Strahlung oder Teilchenstrahlung, insbesondere einen Halbleiter-Detektor zum Nachweis oder zur Spektroskopie von ionisierender Strahlung oder geladenen Teilchen.

Es ist bekannt, zur Strahlungsdetektion Halbleiter-Driftdetektoren (auch: Halbleiter-Driftkammern, Halbleiter-Driftdioden, insbesondere Silizium-Driftdetektoren, -driftkammern oder - drift-dioden) zu verwenden (siehe z. B. US 4 688 067). Ein Driftdetektor ist ein großflächiges Halbleiterbauelement mit niedriger Kapazität, das aus einem Halbleiterkörper eines ersten Leitungstyps, z. B. n-Typ besteht, dessen einander gegenüberliegende Hauptoberflächen schichtförmige Gebiete des entgegengesetzten, zweiten Leitungstyps, also z. B. p-Typ, aufweisen. Diese Gebiete bilden vorgespannte Sperrschichten, die als Elektroden verwendet werden, um im Halbleiterkörper ein bestimmtes Potential zur Sammlung strahlungsgenerierter Ladungsträger auszubilden.

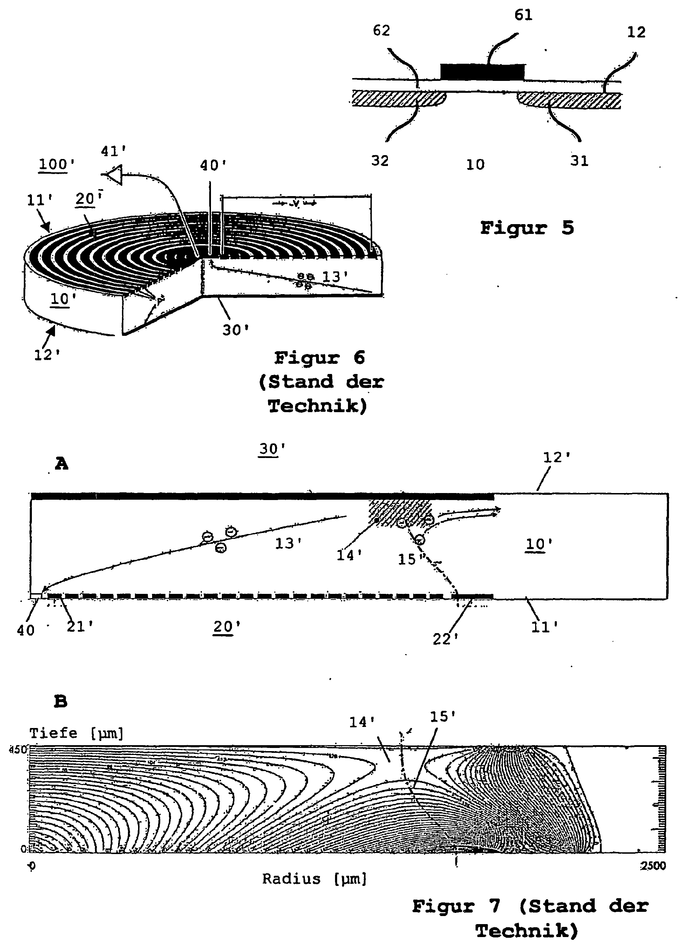

Ein herkömmlicher Driftdetektor, insbesondere für die spektroskopische, d. h. energieaufgelöste Messung, z. B. von Röntgenstrahlung ist schematisch in Fig. 6 illustriert. Der Driftdetektor 100' umfasst einen Halbleiterkörper 10' z. B. vom n-Typ, auf dessen im Bild oberen Hauptoberfläche 11' p-dotierte Driftelektroden 20' ringförmig angeordnet sind. In der Mitte der ersten Hauptoberfläche 11' ist eine Signalelektrode 40' (Ausleseelektrode) vorgesehen, die einen Ohm' schen Anschluss zum Halbleiterkörper 10' bildet. Auf der gegenüberliegenden zweiten Hauptoberfläche 12' ist ein großflächiges, unstrukturiertes, sperrgepoltes Gebiet vorgesehen, das eine Gegenelektrode 30' ebenfalls mit p-Dotierung bildet. Die Gegenelektrode 30', die eine Fläche konstanten Potentials darstellt, bildet ein Strahlungseintrittsfenster, durch das die nachzuweisende Strahlung einfällt (siehe z. B. WO 85/04987).

Zum Detektorbetrieb sind die Driftelektroden 20' und die Gegenelektrode 30' gegenüber dem Halbleiterkörper 10' so in Sperrrichtung gepolt, dass annähernd der gesamte Querschnitt des Halbleiterkörpers 10' von beweglichen Ladungsträgern verarmt wird und ein Potentialminimum für Majoritätsladungsträger des ersten Leitungstyps, also z. B. Elektronen, im Inneren des Halbleiterkörpers 10' entsteht. Durch Anlegen einer nach außen hin zunehmenden Spannung an die Driftelektroden 20' wird das Potentialminimum als kontinuierlicher Potentialgradient 13' gebildet.

Durch die Absorption ionisierender Strahlung im verarmten Volumen des Halbleiterkörpers 10' werden Majoritätsladungsträger (hier: Elektronen) generiert, die im elektrischen Feld des Potentialgradienten zur Signalelektrode 40' driften, wo sie ein Messsignal liefern. Das Messsignal wird mit einem Verstärker 41', der ggf. in den Halbleiterkörper 10' integriert ist, verstärkt und anschließend ausgewertet. Die bei Strahlungsabsorption generierten Minoritätsladungsträger (hier: Löcher) werden durch die sperrgepolten Gebiete abgezogen und tragen nicht zum Signal bei. Da die Kapazität der Signalelektrode 40' extrem gering ist, wird durch die Driftdetektor-Struktur vorteilhafterweise eine rauscharme und schnelle Auslese des Signals erlaubt. Driftdetektoren sind dadurch insbesondere für die Einzelphotonenzählung (Messung einzelner Strahlungsquanten oder Teilchen) geeignet, wobei durch die Verwendung der flächigen Gegenelektrode 30' homogene Absorptionsverhältnisse im Halbleiterkörper 10' und dadurch eine energetisch schmale Signalantwortfunktion des Driftdetektors mit geringem Untergrund erzielt werden.

Die Verwendung der unstrukturierten, großflächigen Gegenelektrode 30' als Strahlungseintrittsfenster besitzt jedoch einen wesentlichen Nachteil für die Potentialverteilung im Inneren des Halbleiterkörpers 10', der im Folgenden unter Bezug auf die Fign. 7A, 7B erläutert wird. In Fig. 7A ist eine Schnittansicht des Halbleiterkörpers 10' mit den Driftelektroden 20' und der Gegenelektrode 30' gezeigt. Fig. 7B illustriert die entsprechenden Potentialverhältnisse im Halbleiterkörper 10'.

Bei Beaufschlagung der Driftelektroden 20' mit einem Spannungsgradienten zwischen bspw. -250 V bei der äußeren Driftelektrode 22' bis -10 V bei der inneren Driftelektrode 21' und einer Beaufschlagung der Gegenelektrode 30' mit einer konstanten Spannung von -125 V ergibt sich der annähernd diagonale Verlauf des Potentialminimums 13' im Halbleiterkörper 10'. Am äußeren Rand des Driftdetektors kommt es jedoch gegenüber dem äußeren, nicht verarmten Gebiet zu starken elektrischen Feldern, die störend in den Potentialverlauf im Halbleiterkörper 10' zwischen den Elektroden eingreifen. Im Bereich der sperrenden Driftelektrode mit der betragsmäßig höchsten Sperrspannung, d. h. am Rand der sensitiven Detektorfläche entsteht nahe der Gegenelektrode 30' parallel zur zweiten Hauptoberfläche 12' eine Region 14' mit annähernd konstantem Potential und geringer elektrischer Feldstärke. Majoritätsladungsträger, die in dieser Region 14' generiert werden, verweilen wegen der geringen elektrischen Feldstärke für eine relativ lange Zeit in diesem fast feldfreien Raum. In dieser Verweilzeit dehnt sich die räumliche Verteilung der Signalladungen durch Diffusion erheblich aus. Dadurch verlängert sich die Ladungssammlungszeit und folglich auch die Signalanstiegszeit. Dadurch wird eine räumlich inhomogene Antwortfunktion des Driftdetektors gebildet. Die Messsignale sind für eine spektroskopische Auswertung nur eingeschränkt verwendbar.

Ein weiteres Problem besteht darin, dass am äußeren Rand des Driftdetektors nahe der Strahlungseintrittsseite (Gegenelektrode 30') keine oder eine nur geringe Potentialbarriere gegenüber dem nicht verarmten äußeren Bereich des Halbleiterkörpers gegeben ist. Die niedrige Potentialbarriere zum nicht verarmten Bereich begünstigt einen teilweisen Verlust von Signalladungen. In Fig. 7 ist mit einer Strich-Punkt-Linie 15' der Verlauf der Grenze eingezeichnet, entlang derer die generierten Ladungsträger entweder in den verarmten Bereich hin zur Signalelektrode 40' flie-ßen oder hin zum Rand des Detektors verloren gehen. Nachteilig ist auch, dass die Grenze 15' wegen der starken elektrischen Feldern am Detektorrand in den Halbleiterkörper 10' unterhalb der Gegenelektrode 30' verschoben wird. Damit können Ladungsträger, obwohl sie unter dem Strahlungseintrittsfenster generiert worden sind, für die Messung verloren gehen.

Beide nachteiligen Effekte, also die Variationen der Signalanstiegszeit je nach Ort der Ladungsträgergeneration und die Signalladungsverluste, beeinträchtigen die Energieauflösung des Driftdetektors. Bei herkömmlichen Driftdetektoren hat man versucht, die Absorption ionisierender Strahlung und damit die Ladungsträgergeneration in den feldfreien Regionen durch Abdecken des Randbereiches mittels eines Kollimators auszuschließen. Das Aufbringen eines Kollimators mit einer technisch bedingten Justagetoleranz führt jedoch zu einem erheblichen Verlust an empfindlicher Detektorfläche. Das Verhältnis von geometrischer zu tatsächlich nutzbarer Detektorfläche wird verschlechtert.

Es sind auch Mehrkanal-Driftdetektoren bekannt, bei denen eine Vielzahl von Detektorstrukturen gemäß Fig. 6 bspw. wabenartig als Detektorzellen nebeneinander angeordnet sind. Während für alle Detektorzellen eine gemeinsame Gegenelektrode vorgesehen ist, weist jede einzelne Detektorzelle eine eigene Signalelektrode auf. Dies ermöglicht die gleichzeitige energieselektive Detektion einzelner Strahlungsquanten. Bei Mehrkanal-Driftdetektoren treten die o. g. Probleme nicht nur am Detektorrand, sondern auch entlang der Zellengrenzen auf. An den Zellengrenzen, von denen jeweils Potentialgradienten hin zu den Signalelektroden in der Mitte der benachbarten Zellen beginnen, entstehen oberflächennah fast feldfreie Regionen, in denen sich die Ladungssammlungszeit erhöht. Des Weiteren können Signalladungen in benachbarte Detektorzellen abwandern und damit das Messsignal verfälschen.

Der genannte Nachteil eines Verlusts von Signalladungsträgern kann außer an den Randbereichen eines Detektors oder an den Zellengrenzen von Mehrkanaldetektoren ebenfalls auftreten, wenn in der oberen Hauptoberfläche 11' innerhalb der Driftelektroden 20' zusätzliche Detektorkomponenten integriert sind, die einen Bereich mit lokal reduzierter Ladungsträgersammlungseffizienz zur Folge haben. Solche Bereiche können beispielsweise durch die Integration von Elementen der Verstärkerelektronik entstehen.

Die Aufgabe der Erfindung ist es, einen verbesserten Halbleiter-Detektor bereitzustellen, mit dem die Nachteile der herkömmlichen Detektoren überwunden werden und der sich durch eine erhöhte Effektivität, Reproduzierbarkeit und Genauigkeit der Strahlungsdetektion auszeichnet. Der Detektor soll insbesondere die Vorteile der Verwendung eines nicht strukturierten Strahlungseintrittsfensters (großflächige Gegenelektrode) beibehalten und dabei die Nachteile der oben beschriebenen feldfreien Regionen vermeiden. Eine Aufgabe der Erfindung ist es insbesondere, einen verbesserten Halbleiter-Detektor bereitzustellen, der sich durch eine verbesserte Ausnutzung der Fläche des Strahlungseintrittsfensters und damit durch eine erhöhte Detektionseffektivität auszeichnet. Der Detektor soll sich insbesondere für energieaufgelöste Messungen mit einer schmalen spektralen Antwortfunktion bei geringem niederenergetischem Untergrund eignen.

Diese Aufgaben werden durch einen Halbleiter-Detektor mit den Merkmalen gemäß dem Patentanspruch 1 gelöst. Vorteilhafte Ausführungsformen und Anwendungen der Erfindung ergeben sich aus den abhängigen Ansprüchen.

Eine Grundidee der Erfindung ist es, einen Halbleiter-Detektor zur Detektion von elektromagnetischer Strahlung oder von Teilchenstrahlung mit einem Halbleiterkörper (Halbleitersubstrat), auf dessen Hauptoberflächen einerseits Driftelektroden und andererseits eine Gegenelektrodenanordnung als vorgespannte Sperrschichten gebildet sind, dahingehend weiterzuentwickeln, dass die Gegenelektrodenanordnung eine flächige, unstrukturierte Hauptelektrode und mindestens eine Barrierenelektrode umfasst, die gegenüber dem Halbleiterkörper stärker in Sperrrichtung gepolt ist als die Hauptelektrode. Die Hauptelektrode und die mindestens eine Barrierenelektrode bilden das Strahlungseintrittsfenster des erfindungsgemäßen Halbleiter-Detektors. Die für die Detektion nutzbare Fläche des Strahlungseintrittsfensters wird vorteilhafterweise durch eine Verkleinerung der feldfreien Regionen und deren Verschiebung in die Tiefe des Halbleiterkörpers und eine Verschärfung der Gradienten an der Grenze zwischen verarmtem und nicht verarmtem Bereich des Halbleiterkörpers unter der Wirkung der mindestens einen Barrierenelektrode vergrößert. Die Wirkungsweise der mindestens einen Barrierenelektrode wird mit weiteren Einzelheiten unten erläutert.

Unter einer flächig und unstrukturiert gebildeten Hauptelektrode wird hier eine Elektrodenschicht oder eine Gruppe von miteinander elektrisch verbundenen Elektrodenschichten verstanden, die jeweils eine Fläche entsprechend der Fläche besitzen, die eine Gruppe von Driftelektroden auf der gegenüberliegenden Oberfläche des Halbleiterkörpers einnehmen, und jeweils eine geschlossene Schicht ohne Teilstrukturen bilden.

Erfindungsgemäß können die Halbleiterelektroden (Drift- und Gegenelektroden) p-dotiert sein, während der Halbleiterkörper n-dotiert ist. Alternativ können die Halbleiterelektroden n-dotiert sein, während der Halbleiterkörper p-dotiert ist.

Gemäß einer bevorzugten Ausführungsform der Erfindung wird die Hauptelektrode in der Ebene der zweiten Hauptoberfläche des Halbleiterkörpers von der Barrierenelektrode ganz oder teilweise umschlossen. Beispielsweise bildet die Barrierenelektrode bei einem Einkanal-Driftdetektor einen Ring um die Hauptelektrode. Alternativ kann erfindungsgemäß vorgesehen sein, dass die mindestens eine Barrierenelektrode stückweise einzelne Teilbereiche (Zellenbereiche) der Hauptelektrode ganz oder teilweise umgibt. Diese Gestaltung ist bspw. bei Mehrkanal-Driftdetektoren vorgesehen. Mit Barrierenelektroden, die Teilbereiche der Hauptelektrode entsprechend den Ausdehnungen der Detektorzellen umschlie-ßen, wird eine verbesserte Zuordnung der detektierten Ladungsträger zu den einzelnen Zellen erzielt.

Die mindestens eine Barrierenelektrode kann von einer leitfähigen, relativ zur Barrierenelektrode isolierten Brücke derart unterbrochen sein, dass eine elektrische Verbindung von einem Zellenbereich der Hauptelektrode mit anderen Zellenbereichen oder von einem nicht dotierten Bereich zwischen der Barrierenelektrode und der Hauptelektrode mit dem Halbleiterkörper gebildet wird. Die Verknüpfung von verschiedenen Teilbereichen der Hauptelektrode kann insbesondere beim Anschluß der Hauptelektroden eines Mehrkanal-Driftdetektors an eine externe Spannungsversorgung von praktischem Vorteil sein. Die Verknüpfung des nicht dotierten Bereiches mit dem Halbleiterkörper kann für die Vermeidung von thermisch generierten Leck- oder Dunkelströmen von Vorteil sein.

Gemäß einer abgewandelten Ausführungsform der Erfindung kann die mindestens eine Barrierenelektrode in der zweiten Hauptoberfläche in Bereichen angeordnet sein, die weiteren potentialbeeinflussenden Elementen (z. B. schichtförmige Schaltungskomponenten, wie beispielsweise ein signalverstärkender Transistor) auf der ersten Hauptoberfläche gegenüberliegen. Vorteilhafterweise kann damit die Ladungsträgersammlungszeit und -effektivität verbessert werden.

Gemäß einer weiteren bevorzugten Ausführungsform der Erfindung besitzt die mindestens eine Barrierenelektrode eine laterale Breite (Ausdehnung in der Ebene der zweiten Hauptoberfläche), die mindestens gleich einem Viertel des Betrages der Dicke des Halbleiterkörpers ist. Dadurch kann die feldfreie Region (Sattelpunkt) von der Oberfläche in die Tiefe des Halbleiterkörpers verschoben werden. Damit können die Signalladungsverluste vorteilhafterweise vermindert werden, da bei der Absorption elektromagnetischer Strahlung die meisten Ladungsträger nahe der Oberfläche generiert werden.

Die mindestens eine Barrierenelektrode kann erfindungsgemäß aus dotiertem Halbleitermaterial mit dem zweiten Leitungstyp oder alternativ aus Metall bestehen, so dass mit dem Halbleiterkörper ein Schottky-Übergang gebildet wird. Die erste Variante kann Vorteile in Bezug auf die Herstellung der Barrierenelektrode vorzugsweise mit dem selben Dotierungsstoff wie die Hauptelektrode besitzen.

Erfindungsgemäß kann vorgesehen sein, dass die Hauptelektrode ohne elektrische Verbindung mit anderen potentialführenden Teilen des Detektors vorgesehen ist. Bei dieser Gestaltung wird die Hauptelektrode in einem "floatenden" Zustand betrieben, wodurch sich Vorteile in Bezug auf die Vereinfachung des Detektoraufbaus ergeben können.

Gemäß einer weiteren Abwandlung können außerhalb des Strahlungseintrittsfensters, das durch die Hauptelektrode und die mindestens eine Barrierenelektrode gebildet wird, zusätzliche Abschirmelektroden oder sog. Guard-Elektroden vorgesehen sein. Die Abschirmelektroden können sich vorteilhaft auf die Vermeidung hoher elektrischer Felder am Detektorrand auswirken.

Vorteilhafterweise besitzt der erfindungsgemäße Halbleiter-Detektor einen breiten Anwendungsbereich beim Nachweis und bei der spektroskopischen, d. h. energieaufgelösten Messung von ionisierender Strahlung (z. B. geladene Teilchen) oder elektromagnetischer Strahlung im Wellenlängenbereich der Gamma-, Röntgen-, UV-Strahlung oder des sichtbaren Lichtes. Eine bevorzugte Anwendung besteht in der Schaffung eines Driftdetektors für die Röntgenspektroskopie. Alternativ kann der erfindungsgemäße Halbleiter-Detektor auch einen PAD-Detektor oder einen anderen Pixelbasierten Halbleiter-Detektor bilden.

Weitere Vorteile und Einzelheiten der Erfindung werden im Folgenden unter Bezug auf die beigefügten Zeichnungen beschrieben. Es zeigen:
- Fig. 1: eine schematische Draufsicht auf einen erfindungsgemäßen Einkanal-Detektor,
- Fign. 2A, B: Illustrationen der Potentialverhältnisse im Detektor gemäß Fig. 1 entlang der Linie II-II,
- Fig. 3: eine schematische Draufsicht auf einen erfindungsgemäßen Mehrkanal-Detektor,
- Fign. 4A, B: Illustrationen der Potentialverhältnisse im Detektor gemäß Fig. 3 entlang der Linie IV-IV,
- Fig. 5: eine schematische Illustration der Anordnung von Feldplatten, und
- Fign. 6, 7: Illustrationen des Aufbaus und der Potentialverhältnisse eines herkömmlichen Driftdetektors.

Die Erfindung wird im Folgenden beispielhaft unter Bezug auf einen Halbleiter-Driftdetektor zur Röntgenspektroskopie beschrieben. Die Erfindung ist jedoch auf diese Anwendung nicht beschränkt, sondern bei anderen Halbleiter-Detektoren entsprechend anwendbar. Die Erfindung ist insbesondere durch die Gestaltung des Strahlungseintrittsfensters eines Halbleiter-Detektors mit einer Gegenelektrode und mindestens einer Barrierenelektrode charakterisiert. Weitere Merkmale von Halbleiter-Detektoren, wie z. B. die Gestaltung des Halbleiterkörpers, der Driftelektroden, der Ausleseelektroden oder weiterer Schaltungskomponenten sind an sich von herkömmlichen Halbleiter-Detektoren bekannt und werden daher hier im Einzelnen nicht beschrieben.

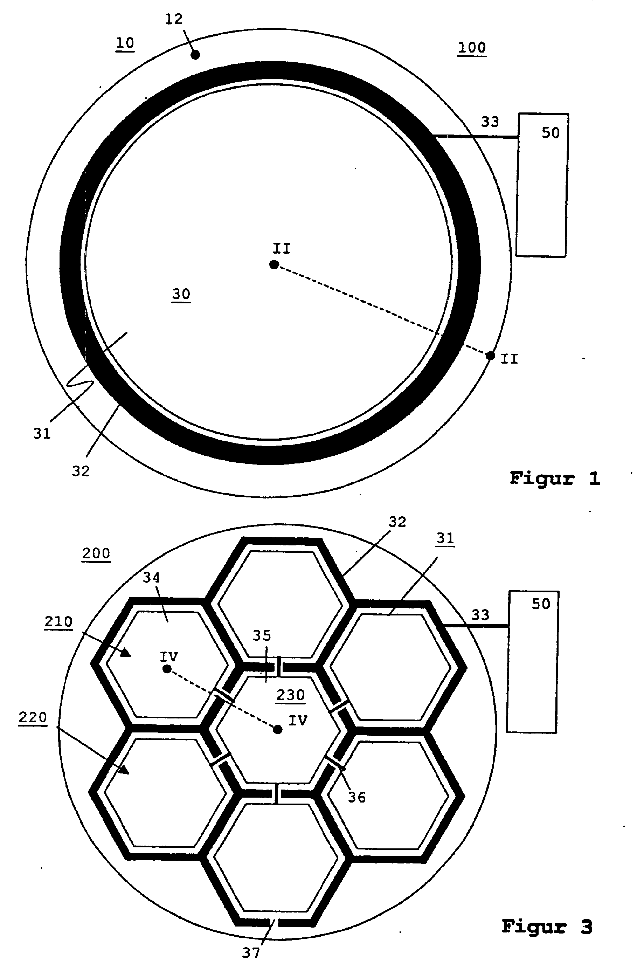

Figur 1 zeigt beispielhaft einen Driftdetektor 100 in schematischer, vergrößerter Draufsicht mit Blick auf die zweite Hauptoberfläche 12 mit dem Strahlungseintrittsfenster 30. Der Driftdetektor 100 ist als Einkanal-Detektor-mit Zylindersymmetrie entsprechend der an sich bekannten Bauweise eines Standard-Single-Driftdetektors aufgebaut. Das Strahlungseintrittsfenster 30 ist als Gegenelektrodenanordnung des Driftdetektors 100 anstelle der Gegenelektrode 30' beispielsweise eines herkömmlichen Driftdetektors gemäß Fig. 5 vorgesehen. Das Strahlungseintrittsfenster 30 umfasst erfindungsgemäß die flächige, unstrukturierte Hauptelektrode 31 und die ringförmige Barrierenelektrode 32, die die Hauptelektrode 31 umgibt. Beide Elektroden 31, 32 sind als dotierte Sperrschichten auf einer der Hauptoberflächen des Halbleiterkörpers 10 gebildet. Die Elektroden 31, 32 sind mit Abstand voneinander angeordnet. Zwischen ihnen befindet sich ein isolierender Ring aus undotiertem Halbleitermaterial.

Die Barrierenelektrode 32 ist erfindungsgemäß über die elektrische Verbindungsleitung 33 mit einer Spannungsquelle 50 verbunden. Die Spannungsquelle 50 ist dazu vorgesehen, die Barrierenelektrode 32 mit einer Sperrspannung zu beaufschlagen, die größer als die Sperrspannung der Hauptelektrode 31 relativ zum Halbleiterkörper 10 ist.

Der Halbleiterkörper 10 ist bspw. n-leitendes Silizium, während die Elektroden 31, 32 den entgegengesetzten Leitungstyp, also p-Leitung aufweisen. Die Elektroden 31, 32 werden vorzugsweise durch Dotierung des Halbleitermaterials gebildet, auf dessen Grundlage der Halbleiterkörper hergestellt ist. Alternativ kann der Halbleiterkörper z. B. aus Germanium, Gallium-Arsenid, Cadmium-Tellurid oder Cadmium-Zink-Tellurid gebildet sein.

Die Dicke des Halbleiterkörpers 10 ist vorzugsweise im Bereich von 200 µm bis 500 µm gewählt. Die Ausdehnung der Hauptelektrode 31 beträgt bspw. 1 mm bis 5 mm. Die laterale Breite der Barrierenelektrode 32 beträgt beispielsweise 100 µm und ist mindestens so gewählt, dass eine Kontaktierung mit einer Verbindungsleitung 33 ermöglicht wird. Die laterale Breite ist vorzugsweise mindestens gleich einem Viertel der Dicke des Halbleiterkörpers 10. Bei einer Dicke von z. B. 450 µm beträgt die Breite bspw. rd. 225 µm. Der isolierende Abstand zwischen den Elektroden besitzt eine Breite von bspw. 10 µm. Die Gesamtfläche des Strahlungseintrittsfensters 30 beträgt bspw. 12 mm².

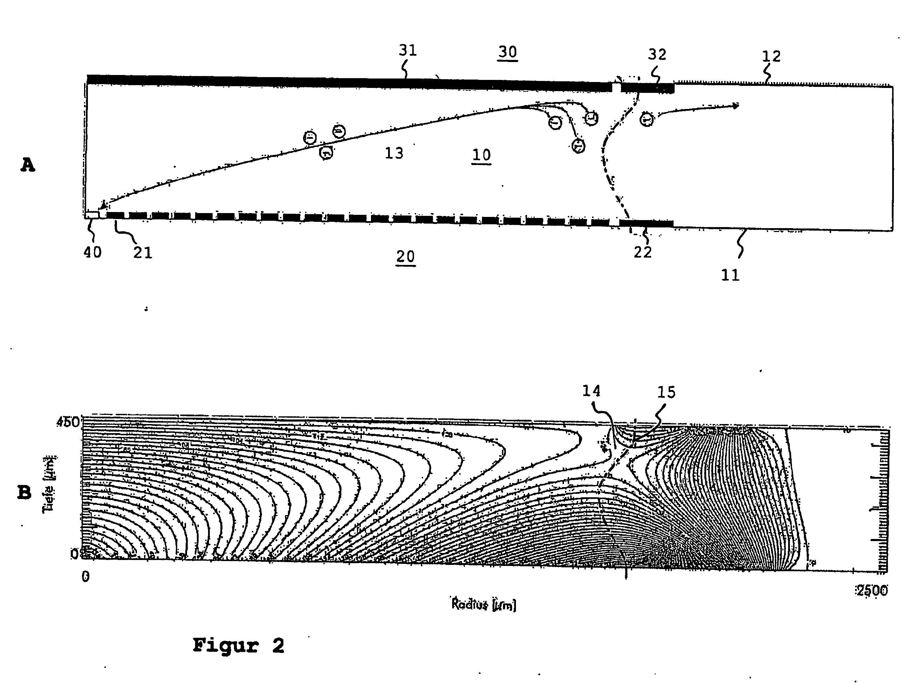

Die Wirkung der Barrierenelektrode 32 wird im Folgenden unter Bezug auf die Fign. 2A, B erläutert. In Fig. 2A ist eine vergrößerte Schnittdarstellung des Driftdetektors gemäß Fig. 1 entlang der Linie II-II gezeigt. Auf der ersten Hauptoberfläche 11 des Halbleiterkörpers 10 sind die Driftelektroden 20 und die Signalelektrode 40 angeordnet. Auf der gegenüberliegenden zweiten Hauptoberfläche 12 befinden sich die Hauptelektrode 31 und die Barrierenelektrode 32, die mit der Spannungsquelle verbunden ist. Die Driftelektroden 20 einerseits und die Elektroden 31, 32 andererseits nehmen annähernd die gleiche Fläche ein. Zur Strahlungsdetektion werden im Betriebszustand des Driftdetektors bspw. die folgenden Spannungen eingestellt: Hauptelektrode 31: -125 V, Barrierenelektrode 32: -150 V, Driftelektroden 20: Spannungsgradient ansteigend von -10 V bei der innersten Driftelektrode 21 bis auf -250 V bei der äußersten Driftelektrode 22. Der Spannungsgradient an den Driftelektroden wird so eingestellt, dass sich ein im Wesentlichen diagonal durch den Halbleiterkörper 10 erstreckendes Potentialgefälle 13 zur Sammlung der strahlungsgenerierten Ladungsträger bildet.

In Fig. 2B sind die entsprechenden Potentialverhältnisse gezeigt. Freie Ladungsträger bewegen sich senkrecht zu den gezeichneten Linien konstanten Potentials. Die Majoritätsladungsträger (im Beispiel: Elektronen) fließen am Potentialminimum 13 hin zur Signalelektrode 40 (Ausleseelektrode) in der Mitte des Halbleiterkörpers 10, während die Minoritätsladungsträger annähernd senkrecht zu den beiden Hauptoberflächen 11, 12 fließen. In den Gebieten mit einer hohen Dichte von Potentiallinien herrscht ein starkes elektrisches Feld, das die Ladungsträger beschleunigt.

Durch die Wirkung der Barrierenelektrode 32 ergibt sich im Unterschied zum Potentialbild des herkömmlichen Driftdetektors gemäß Fig. 6 erfindungsgemäß eine deutliche Verringerung der Ausdehnung der nahezu feldfreien Region 14 und damit eine schnellere Drift von dort generierten Majoritätsladungsträgern zur Ausleseelektrode 40. Die Signallaufzeiten aus diesem kritischen Bereich werden gekürzt. Des Weiteren wird die Potentialbarriere, durch die Majoritätsladungsträger in den nicht verarmten Bereich des Halbleiterkörpers 10 abdiffundieren könnten und somit die effektive Detektorfläche vergrößert. Die Potential-Trennlinie 15 (Strich-Punkt-Linie) greift vorteilhafterweise weniger tief in den Halbleiterkörper 10 unterhalb des Strahlungseintrittsfensters 30 ein. Im Vergleich zum herkömmlichen Driftdetektor wird die effektiv nutzbare Fläche des Strahlungseintrittsfensters 30 vergrößert. Des Weiteren wird der Potentialwall verschärft, so dass die Generationsorte von Ladungsträgern, an denen die Driftrichtung zunächst unbestimmt ist, verkleinert werden.

Ein wichtiger Vorteil besteht darin, dass der Sattelpunkt der feldfreien Region 15 in die Tiefe des Halbleiterkörpers 10 unterhalb der zweiten Hauptoberfläche 12 verschoben wird. Da insbesondere bei der Detektion von elektromagnetischer Strahlung die Absorptionswahrscheinlichkeit von Photonen und damit die Häufigkeit von Ladungsträgergenerationsprozessen mit der durchstrahlten Wegstrecke exponentiell abnimmt und daher die meisten Ladungsträger unmittelbar unter der Oberfläche generiert werden, bewirkt die Verschiebung der Region 15 in die Tiefe eine erhebliche Reduzierung der Ladungsträgerzahl, die überhaupt in der Region 15 generiert werden. Die Verschiebung der Region 15 in die Tiefe des Halbleiterkörpers 10 entspricht etwa der lateralen Breite der Barrierenelektrode.

Besonders vorteilhaft ist, dass sogar Ladungsträger, die außerhalb der Hauptelektrode 31 unter der Barrierenelektrode 32 generiert werden, zum Teil zum Messsignal beitragen, da die Potential-Trennlinie erst unterhalb der Barrierenelektrode 32 endet. Im Vergleich zum herkömmlichen Bild ergibt sich ein Zuwachs der nutzbaren Fläche von rd. 20%. Die Ladungsträgersammlungseffizienz ist sprunghaft verbessert.

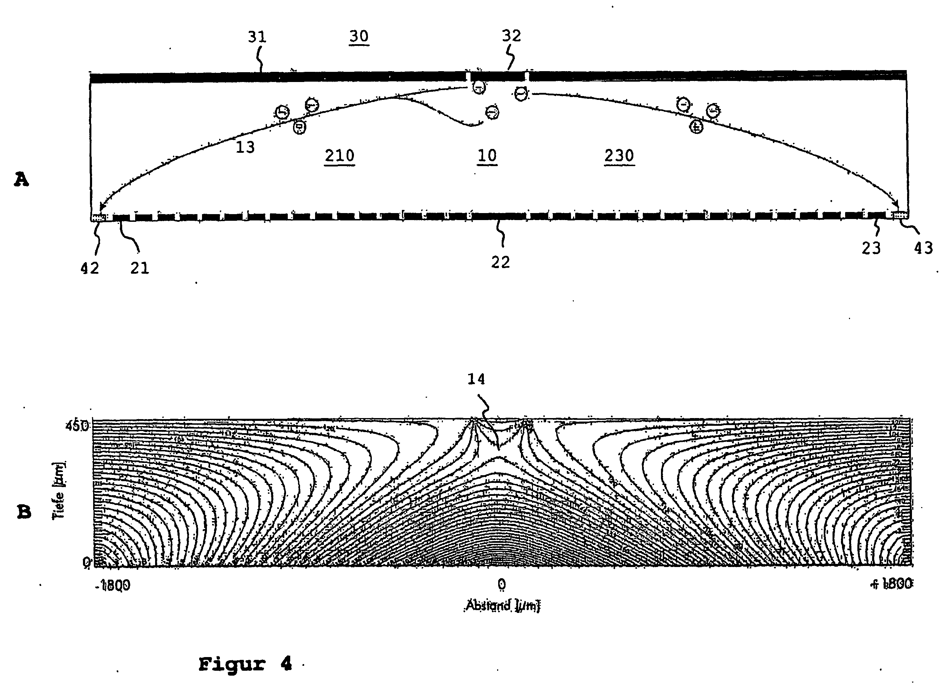

Figur 3 zeigt eine abgewandelte Ausführungsform eines erfindungsgemäßen Driftdetektors 200, der als Mehrkanaldetektor mit einer Vielzahl von wabenförmig angeordneten Detektorzellen 210, 220, 230 ... gebildet ist. Die schematische Draufsicht auf die zweite Hauptoberfläche 12 zeigt ein Strahlungseintrittsfenster 30 mit einer Hauptelektrode 31 und einer Barrierenelektrode 32: Die Hauptelektrode 31 besteht aus einer Anzahl von hexagonalen Elektrodenschichten entsprechend der Anzahl der Detektorzellen. Die hexagonalen Elektrodenschichten werden auch als Zellbereiche 34, 35, ... bezeichnet. Die Zellbereiche 34, 35, ... sind über elektrisch leitfähige Verbindungsbrücken (z. B. bei 36), die gegenüber der Barrierenelektrode 32 isoliert sind, miteinander elektrisch verbunden, so dass alle Zellbereiche der Hauptelektrode 31 ein gemeinsames Potential aufweisen.

Die Barrierenelektrode 32 ist aus einer Vielzahl gerader Elektrodenstreifen zusammengesetzt, die in hexagonaler Form die Zellbereiche der Hauptelektrode 31 einschließen. Die Barrierenelektrode 32 ist über die Verbindungsleitung 33 mit der Spannungsquelle 50 verbunden. Die Größe der Zellbereiche und die Breite des Elektrodenstreifens sind analog zu der Dimensionierung gemäß Fig. 1 gewählt. Eine vergrößerte Schnittdarstellung entlang der Linie IV-IV und die zugehörigen Potentialverhältnisse sind in den Fig. 4A, B gezeigt.

Fig. 4A zeigt die aneinander grenzenden Hälften der Detektorzellen 210, 230, auf deren erster Hauptoberfläche 12 analog zum oben beschriebenen Beispiel Driftelektroden 20 und die Signalelektroden 42, 43 und auf deren zweiter Hauptoberfläche die Hauptelektrode 31 und die Barrierenelektrode 32 angeordnet sind. Im Detektorbetrieb werden die Elektroden mit den folgenden Potentialen beaufschlagt: Hauptelektrode 31: -125 V, Barrierenelektrode 32: -150 V, Driftelektroden: Spannungsgradienten beginnend von den niedrigsten Sperrspannungen -10V bei den Driftelektroden 21, 23, die den Signalelektroden 42, 43 benachbart sind, über die maximale Sperrspannung -250 V in der mittleren Driftelektrode 22 an der Zellengrenze zwischen den benachbarten Detektorzellen 210, 230. Im vollständig verarmten, n-leitenden Substrat bilden sich diagonal verlaufende Potentialgradienten 13, an deren Minima die Ladungsträger hin zu den Signalelektroden 42, 43 gesammelt werden.

Die Wirkung der Barrierenelektrode 32 ist im Potentialbild der Fig. 4B gezeigt. Die nahezu feldfreie Region 14 mit dem Sattelpunkt zwischen den Potentialverläufen ist verkleinert und in die Tiefe des Halbleiterkörpers 10 verschoben. Außerdem ist die Potentialbarriere zwischen den benachbarten Detektorzellen verschärft. Vorteilhafterweise können dadurch detektierte Teilereignisse, die zum einen Photon gehören, in der Signalauswertung besser getrennt werden.

Erfindungsgemäße Driftdetektoren können die folgenden weiteren Merkmale aufweisen. Um das Strahlungseintrittsfenster 30 können zusätzlich äußere Abschirmringe zum Potentialabbau gegenüber der Umgebung vorgesehen sein. Am Strahlungseintrittsfenster kann ein Kollimator angeordnet sein, der jedoch im Unterschied zu den Kollimatoren an herkömmlichen Detektoren eine größere Fläche als empfindliche Detektorfläche freilässt.

Des Weiteren kann vorgesehen sein, alle Oberflächengebiete des Halbleiterkörpers 10 in der Ebene der zweiten Hauptoberfläche 12 zwischen den Haupt- und Barrierenelektroden 31, 32 elektrisch miteinander zu verbinden und das Potential dieser Oberflächengebiete sowie der Unterbrechungen (siehe zum Beispiel Figur 3, Bezugszeichen 36, 37) der Barrierenelektrode mittels Feldplatten, zum Beispiel in Ausführung als Metall-Oxid-Halbleiter-Elemente (61, 62, siehe Figur 5), festzulegen. Vorteilhafterweise können dadurch Leckströme, die vermehrt in diesen Bereichen durch störstellenunterstützte thermische Generation von Ladungsträgern entstehen können, zum nicht verarmten Bereich des Halbleiterkörpers abgeführt und damit die Energieauflösung des Detektors verbessert werden.

Die mindestens eine Barrierenelektrode kann in der zweiten Hauptoberfläche zum Beispiel in der Mitte angeordnet sein, wo gegenüber liegend auf der ersten Hauptoberfläche an der Signalelektrode zum Beispiel ein verstärkender Transistor, der eine reduzierte Ladungssammlungseffizienz in einer lokal begrenzten Region verursachen kann, vorgesehen ist.

Die in der Beschreibung, den Zeichnungen und den Ansprüchen offenbarten Merkmale der Erfindung können sowohl einzeln als auch in Kombination für die Verwirklichung der Erfindung in ihren verschiedenen Ausgestaltungen von Bedeutung sein.

## Patentansprüche

1. Halbleiter-Detektor (100, 200) zur Detektion von elektromagnetischer Strahlung oder Teilchenstrahlung, der umfasst:
- einen Halbleiterkörper (10) eines ersten Leitungstyps mit ersten und zweiten Hauptoberflächen (11, 12),
- eine Gruppe von Driftelektroden (20, 21, 22, 23) mit einem zweiten, entgegengesetzten Leitungstyp, die auf der ersten Hauptoberfläche (11) zur Erzeugung mindestens eines Driftfeldes im Halbleiterkörper (10) angeordnet sind, und
- eine Gegenelektrodenanordnung (30), die auf der zweiten Hauptoberfläche (12) angeordnet ist, den zweiten Leitungstyp aufweist und ein Strahlungseintrittsfenster bildet,
**dadurch gekennzeichnet, dass**
- die Gegenelektrodenanordnung (30) eine flächige Hauptelektrode (31) und mindestens eine Barrierenelektrode (32) umfasst, die elektrisch voneinander isoliert sind, wobei
- die mindestens eine Barrierenelektrode (32) mit einer Spannungsquelle (50) verbunden und dazu eingerichtet ist, relativ zum Halbleiterkörper (10) mit einer Sperrspannung beaufschlagt zu werden, die größer als die Sperrspannung der Hauptelektrode (31) ist.

2. Halbleiter-Detektor nach Anspruch 1, bei dem die mindestens eine Barrierenelektrode (32) in der Ebene der zweiten Hauptoberfläche (12) die Hauptelektrode (31) ganz oder teilweise umgibt.

3. Halbleiter-Detektor nach Anspruch 2, bei dem die mindestens eine Barrierenelektrode (32) in der Ebene der zweiten Hauptoberfläche Zellenbereiche (34, 35) der Hauptelektrode (31) ganz oder teilweise umgibt.

4. Halbleiter-Detektor nach Anspruch 2 oder 3, bei dem die mindestens eine Barrierenelektrode (32) die Hauptelektrode (31) oder deren Zellenbereiche (33, 34) teilweise derart umgibt, dass in der Barrierenelektrode (32) jeweils eine Unterbrechung mit einer leitfähigen Brücke (36, 37) gebildet ist, die verschiedene Zellenbereiche (34, 35) oder die Oberflächengebiete des Halbleiterkörpers (10) in der Ebene der zweiten Hauptoberfläche (12) zwischen den Hauptelektroden (31) und Barrierenelektroden (32) elektrisch miteinander verbindet.

5. Halbleiter-Detektor nach einem der vorhergehenden Ansprüche, bei dem die Oberflächengebiete des Halbleiterkörpers (10) in der Ebene der zweiten Hauptoberfläche (12) zwischen den Haupt-und Barrierenelektroden (31, 32) oder die Unterbrechungen (36, 37) der Barrierenelektrode ganz oder teilweise mit Feldplatten bedeckt sind.

6. Halbleiter-Detektor nach einem der vorhergehenden Ansprüche, bei dem die mindestens eine Barrierenelektrode in der Ebene der zweiten Hauptoberfläche (12) in Bereichen angeordnet ist, bei denen gegenüber liegend auf der ersten Hauptoberfläche (11) Regionen mit reduzierter Ladungssammlungseffizienz bestehen.

7. Halbleiter-Detektor nach einem der vorhergehenden Ansprüche, bei dem die mindestens eine Barrierenelektrode (32) eine laterale Breite aufweist, die mindestens gleich einem Viertel Dicke des Halbleiterkörpers (10) ist.

8. Halbleiter-Detektor nach einem der vorhergehenden Ansprüche, bei dem die mindestens eine Barrierenelektrode (32) aus dotiertem Halbleitermaterial mit dem zweiten Leitungstyp besteht.

9. Halbleiter-Detektor nach einem der vorhergehenden Ansprüche 1 bis 7, bei dem die mindestens eine Barrierenelektrode (32) aus Metall besteht und mit dem Halbleiterkörper (10) einen Schottky-Übergang bildet.

10. Halbleiter-Detektor nach einem der vorhergehenden Ansprüche, bei dem die Hauptelektrode ohne elektrische Verbindung mit anderen potentialführenden Teilen des Detektors angeordnet ist.

11. Halbleiter-Detektor nach einem der vorhergehenden Ansprüche, bei dem außerhalb des Strahlungseintrittsfensters (30) Abschirmelektroden vorgesehen sind.

12. Halbleiter-Detektor nach einem der vorhergehenden Ansprüche, der einen Driftdetektor (100, 200) zur Röntgenspektroskopie umfasst.

13. Halbleiter-Detektor nach Anspruch 12, bei dem der Driftdetektor einen Mehrkanal-Detektor (200) mit mehreren, aneinander anschließenden Detektorzellen (210, 220, 230,..) umfasst.

14. Halbleiter-Detektor nach einem der vorhergehenden Ansprüche 1 bis 11, der einen PAD-Detektor zur Teilchendetektion umfasst.

## Claims

1. Semiconductor detector (100, 200) for detecting electromagnetic radiation or particle radiation and comprising:
- a semiconductor body (10) of a first conduction type having first and second main surfaces (11, 12),
- a group of drift electrodes (20, 21, 22, 23) of a second, opposite conduction type, which are arranged on the first main surface (11) to generate at least one drift field in the semiconductor body (10), and
- a counter-electrode arrangement (30), which is arranged on the second main surface, is of the second conduction type and forms a radiation entry window,
**characterised in that**
- the counter-electrode arrangement (30) comprises a two-dimensional main electrode (31) and at least one barrier electrode (32), which are electrically insulated from each other,
- the at least one barrier electrode (32) being connected to a voltage source (50) and being so arranged that a blocking voltage can be applied to it relative to the semiconductor (10), said blocking voltage being greater than the blocking voltage of the main electrode (31).

2. Semiconductor detector according to claim 1, in which the at least one barrier electrode (32) in the plane of the second main surface (12) encloses the main electrode (31) completely or partially.

3. Semiconductor detector according to claim 2, in which the at least one barrier electrode (32) in the plane of the second main surface encloses cell regions (34, 35) of the main electrode (31) completely or partially.

4. Semiconductor detector according to claim 2 or 3, in which the at least one barrier electrode (32) partially surrounds the main electrode (31) or its cell regions (33, 34) in such a way that in the barrier electrode (32) in each case an interruption with a conductive bridge (36, 37) is formed, which bridge electrically interconnects various cell regions (34, 35) or the surface regions of the semiconductor body (10) in the plane of the second main surface (12) between the main electrodes (31) and barrier electrodes (32).

5. Semiconductor detector according to one of the preceding claims, in which the surface regions of the semiconductor body (10) in the plane of the second main surface (12) between the main electrodes and barrier electrodes (31, 32) or the interruptions (36, 37) of the barrier electrode are completely or partially covered with field plates.

6. Semiconductor detector according to one of the preceding claims, in which the at least one barrier electrode in the plane of the second main surface (12) is arranged in regions in which, opposite, on the first main surface (11) there are regions of reduced charge collection efficiency.

7. Semiconductor detector according to one of the preceding claims, in which the at least one barrier electrode (32) has a lateral width which is at least equal to a quarter of the thickness of the semiconductor body (10).

8. Semiconductor detector according to one of the preceding claims, in which the at least one barrier electrode (32) comprises doped semiconductor material of the second conduction type.

9. Semiconductor detector according to one of the preceding claims 1 to 7, in which the at least one barrier electrode (32) consists of metal and forms a Schottky junction with the semiconductor body (10).

10. Semiconductor detector according to one of the preceding claims, in which the main electrode is arranged without electrical connection to other potential-carrying components of the detector.

11. Semiconductor detector according to one of the preceding claims, in which shielding electrodes are provided outside the radiation entry window (30).

12. Semiconductor detector according to one of the preceding claims, which comprises a drift detector (100, 200) for X-ray spectroscopy.

13. Semiconductor detector according to claim 12, in which the drift detector comprises a multichannel detector (200) having a plurality of adjoining detector cells (210, 220, 230,...).

14. Semiconductor detector according to one of the preceding claims 1 to 11, which comprises a PAD detector for particle detection.

## Revendications

1. Détecteur semi-conducteur (100, 200) pour la détection d'un rayonnement électromagnétique ou d'un rayonnement de particules, comprenant :
- un corps semi-conducteur (10) d'un premier type de conductivité, avec une première et une deuxième surface principale (11, 12),
- un groupe d'électrodes de dérive (20, 21, 22, 23) d'un deuxième type de conductivité opposé, lesquelles sont disposées sur la première surface principale (11) pour la génération d'au moins un champ de dérive dans le corps semi-conducteur (10), et
- un dispositif de contre-électrode (30) disposé sur la deuxième surface principale (12), lequel présente le deuxième type de conductivité et forme une fenêtre d'entrée de rayonnement,
**caractérisé en ce que**
- le dispositif de contre-électrode (30) comprend une mince électrode principale (31) et au moins une électrode de jonction (32), lesquelles sont isolées électriquement l'une par rapport à l'autre,
- au moins l'une des électrodes de jonction (32) étant en liaison avec une source de tension (50) et étant étudiée pour être alimentée avec une tension d'arrêt par rapport au corps semi-conducteur (10), laquelle est supérieure à la tension d'arrêt de l'électrode principale (31).

2. Détecteur semi-conducteur selon la revendication 1, dans lequel l'une au moins des électrodes de jonction (32) entoure complètement ou partiellement, dans le plan de la deuxième surface principale (12), l'électrode principale (31).

3. Détecteur semi-conducteur selon la revendication 2, dans lequel l'une au moins des électrodes de jonction (32) entoure complètement ou partiellement, dans le plan de la deuxième surface principale, des zones de cellules (34, 35) de l'électrode principale (31).

4. Détecteur semi-conducteur selon les revendications 2 ou 3, dans lequel l'une au moins des électrodes de jonction (32) entoure partiellement l'électrode principale (31) ou la zone de cellules (33, 34) de celle-ci de manière à ce que dans l'électrode de jonction (32), respectivement une interruption est formée avec un pont à conductivité (36, 37), lequel relie électriquement différentes zones de cellules (34, 35) ou bien les régions de surface du corps semi-conducteur (10) dans le plan de la deuxième surface principale (12) entre les électrodes principales (31) et les électrodes de jonction (32).

5. Détecteur semi-conducteur selon l'une quelconque des revendications précédentes, dans lequel les régions de surface du corps semi-conducteur (10), dans le plan de la deuxième surface principale (12) entre les électrodes principales et de jonction (31, 32), ou bien les interruptions (36, 37) de l'électrode de jonction, sont entièrement ou partiellement recouvertes de magnétorésistances.

6. Détecteur semi-conducteur selon l'une quelconque des revendications précédentes, dans lequel l'une au moins des électrodes de jonction dans le plan de la deuxième surface principale (12) est disposée dans des zones pour lesquelles, en vis-à-vis sur la première surface principale (11), se trouvent des zones avec une efficacité réduite d'accumulation de la charge.

7. Détecteur semi-conducteur selon l'une quelconque des revendications précédentes, dans lequel l'une au moins des électrodes de jonction (32) présente une largeur latérale, laquelle est au moins égale au quart de l'épaisseur du corps semi-conducteur (10).

8. Détecteur semi-conducteur selon l'une quelconque des revendications précédentes, dans lequel l'une au moins des électrodes de jonction (32) se compose d'une matière semi-conductrice de dopage du deuxième type de conductivité.

9. Détecteur semi-conducteur selon l'une quelconque des revendications 1 à 7, dans lequel l'une au moins des électrodes de jonction (32) se compose de métal et forme avec le corps semi-conducteur (10) une jonction de Schottky.

10. Détecteur semi-conducteur selon l'une quelconque des revendications précédentes, dans lequel l'électrode principale est disposée sans connexion électrique avec d'autres éléments du détecteur conduisant le potentiel.

11. Détecteur semi-conducteur selon l'une quelconque des revendications précédentes, dans lequel des électrodes de protection sont prévues en dehors de la fenêtre d'entrée du rayonnement (30).

12. Détecteur semi-conducteur selon l'une quelconque des revendications précédentes, lequel comprend un détecteur de champ de dérive (100, 200) pour la spectroscopie aux rayons X.

13. Détecteur semi-conducteur selon la revendication 12, dans lequel le détecteur de champ de dérive comprend un détecteur à voies multiples (200) avec plusieurs cellules de détection (210, 220, 230,...) successives.

14. Détecteur semi-conducteur selon l'une quelconque des revendications 1 à 11, lequel comprend un détecteur PAD pour la détection de particules.
